# EUROPEAN PATENT APPLICATION

(11) **EP 4 550 382 A1**
(43) Date of publication of application: **07.05.2025**
(21) Application number: 23207131.6
(22) Date of filing: 31.10.2023
(51) Int. Cl.: H01J 37/18, H01J 37/16

(54) **CHARGED PARTICLE-OPTICAL DEVICE, CHARGED PARTICLE-OPTICAL APPARATUS AND METHOD FOR MANUFACTURING A CHARGED PARTICLE-OPTICAL DEVICE**

(71) Applicant: ASML Netherlands B.V., 5500 AH Veldhoven (NL)
(72) Inventor: ZIJL, Gomaar, 5500 AH Veldhoven (NL); KONING, Johan, Joost, 5500 AH Veldhoven (NL); DOESBURG, Olivier, Jacob, 5500AH Veldhoven (NL)
(74) Representative: ASML Netherlands B.V.

(57) **Abstract**

A charged particle-optical device 41 for projecting one or more beams of charged particles towards a sample location, the device comprising: an assembly 70 comprising at least one charged particle-optical element 71 configured to operate on one or more beams of charged particles along one or more respective paths for the one or more beams towards a sample location; a frame 75 around the path and connected to the assembly; and a seal 60 around the path, secured between the frame and the assembly, and configured to seal between the frame and the assembly.

## Description

### FIELD

The present disclosure relates to methods and apparatus for assessing a sample using charged particles.

### BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the assessment for example inspection and/or measurement of a surface of a substrate, or other object/material, is an important process during and/or after its manufacture.

Assessment tools, which herein are referred to as assessment systems, are known that use a charged particle beam to assess objects, which may be referred to as samples, for example to detect pattern defects. These systems typically use electron microscopy techniques, such as a scanning electron microscope (SEM). In a SEM, a primary electron beam of electrons at a relatively high energy is targeted with a final deceleration step to land on a sample at a relatively low landing energy. The beam of electrons is focused as a probing spot on the sample. The interactions between the material structure at the probing spot and the landing electrons from the beam of electrons cause signal electrons to be emitted from the surface, such as secondary electrons, backscattered electrons or Auger electrons. The signal electrons may be emitted from the material structure of the sample. By scanning the primary electron beam as the probing spot over the sample surface, signal electrons can be emitted across the surface of the sample. By collecting these emitted signal electrons from the sample surface, a pattern inspection system may obtain an image representing characteristics of the material structure of the surface of the sample.

In an assessment system that uses charged particles, such as an SEM, it is desirable to maintain different levels of vacuum in different regions. For example, it may be desirable to maintain an ultrahigh vacuum at the charged particle source and a high (but not ultrahigh) vacuum closer to a sample. For example, charged particle-optical elements (e.g., electron-optical elements) are provided between the source and the sample to project the charged particles onto the sample. At least some of the charged particle-optical elements may be located relatively close to the sample, where high rates of outgassing and/or charged particle stimulated desorption processes may limit the level of vacuum that is practically achievable. It is desirable to minimize flow of gas from higher pressure regions to lower pressure regions.

### SUMMARY

It is desirable to reduce gas flow between regions maintained at different pressures, without unduly reducing resolution, disrupting alignment or increasing contamination.

According to an aspect of the invention, there is provided a charged particle-optical device for projecting one or more beams of charged particles towards a sample location, the device comprising: an assembly comprising at least one charged particle-optical element configured to operate on one or more beams of charged particles along one or more respective paths for the one or more beams towards a sample location; a frame around the path and connected to the assembly; and a seal around the path, secured between the frame and the assembly, and configured to seal between the frame and the assembly.

According to an aspect of the invention, there is provided a charged particle-optical device for projecting one or more beams of charged particles towards a sample location, the device comprising: an assembly comprising at least one charged particle-optical element configured to operate one or more beams of charged particles along a path for the one or more beams towards a sample location; a frame around the beam path and having a fixed location relative to the assembly; and a planar seal around the beam path, secured between the frame and the assembly, and configured to block gas flow from around the assembly.

According to an aspect of the invention, there is provided a method for manufacturing a charged particle-optical device for projecting one or more beams of charged particles towards a sample location, the method comprising: providing an assembly comprising at least one charged particle-optical element configured to direct one or more beams of charged particles along one or more respective paths for the one or more beams towards a sample location; connecting a frame to the assembly such that the frame is around the path; and securing a seal between the frame and the assembly such that the seal is around the path, the seal configured to seal between the frame and the assembly.

According to an aspect of the invention, there is provided a method for manufacturing a charged particle-optical device for projecting one or more beams of charged particles towards a sample location, the method comprising: providing an assembly comprising at least one charged particle-optical element configured to operate one or more beams of charged particles along a path for the one or more beams towards a sample location; fixing a location of the frame relative to the assembly such that the frame is around the beam path; and securing a planar seal between the frame and the assembly such that the planar seal is around the beam path, the planar seal configured to block gas flow from around the assembly.

### BRIEF DESCRIPTION OF FIGURES

The above and other aspects of the present disclosure will become more apparent from the description of exemplary embodiments, taken in conjunction with the accompanying drawings.
**FIG. 1** is a schematic diagram illustrating an exemplary charged particle beam inspection apparatus.
**FIG. 2** is a schematic diagram illustrating an exemplary multi-beam charged particle-optical apparatus that is part of the exemplary charged particle beam inspection apparatus of **FIG. 1****.**
**FIG. 3** is a schematic diagram of an exemplary charged particle-optical apparatus.
**FIG. 4** is a schematic diagram of an exemplary charged particle-optical device comprising a macro collimator and a macro scan deflector.
**FIG. 5** is a schematic cross-sectional view of a portion of an objective lens array and detector array of an exemplary arrangement.
**FIG. 6** is a bottom view of the portion of the detector array of **FIG. 5****.**
**FIG. 7** is a schematic diagram of an exemplary charged particle-optical apparatus comprising an objective lens array and a beam separator.
**FIG. 8** is a schematic diagram of an exemplary charged particle-optical apparatus comprising a beam tube.
**FIG. 9** is a schematic diagram showing a portion of a charged particle-optical device of **FIG. 2****,** **FIG. 3****,** **FIG. 4****,** **FIG. 7** or **FIG. 8****.**
**FIG. 10** is a schematic diagram showing a portion of the charged particle-optical device of **FIG. 9****.**
**FIG. 11** is a schematic diagram showing a portion of the charged particle-optical apparatus of **FIG. 2****,** or the charged particle-optical device of **FIG. 3****,** **FIG. 4****,** **FIG. 7** or **FIG. 8****.**
**FIG. 12** is a schematic diagram showing a portion of a charged particle-optical device that may be part of the charged particle-optical device of **FIG. 3** or **FIG. 7****.**
**FIG. 13** is a schematic diagram showing a portion of a charged particle-optical device that may be part of the charged particle-optical apparatus of for example **FIG. 3****.**
**FIG. 14** is a schematic diagram showing a portion of a charged particle-optical device of for example **FIG. 3** or **FIG. 7****.**

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000^{th} of a human hair. Thus, it is not surprising that semiconductor IC manufacturing is a complex and time-consuming process, with hundreds of individual steps. Errors in even one step have the potential to dramatically affect the functioning of the final product. Even a single defect can cause device failure in certain situations. The goal of the manufacturing process is to improve the overall yield of the process. For example, to obtain a 75% yield for a 50-step process (where a step can indicate the number of layers formed on a wafer), each individual step must have a yield greater than 99.4%. If each individual step had a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially true if operator intervention is required for reviewing the defects. Thus, high throughput detection and identification of micro and nano-scale defects by inspection systems (such as a SEM) is essential for maintaining high yield and low cost.

A SEM comprises a scanning device and a detector apparatus. The scanning device comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the electron-optical device or column. The primary electrons interact with the sample and generate secondary electrons. The detection apparatus captures the secondary electrons from the sample as the sample is scanned so that the SEM can create an image of the scanned area of the sample. For high throughput inspection, some of the inspection apparatuses use multiple focused beams, i.e. a multi-beam, of primary electrons. The component beams of the multi-beam may be referred to as sub-beams or beamlets. A multi-beam can scan different parts of a sample simultaneously. A multi-beam inspection apparatus can therefore inspect a sample at a much higher speed than a single-beam inspection apparatus.

An implementation of a known multi-beam inspection apparatus is described below.

The figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons throughout the present document may therefore be more generally be considered to be references to charged particles, with the charged particles not necessarily being electrons. All references to charged particles may be considered to include at least electrons.

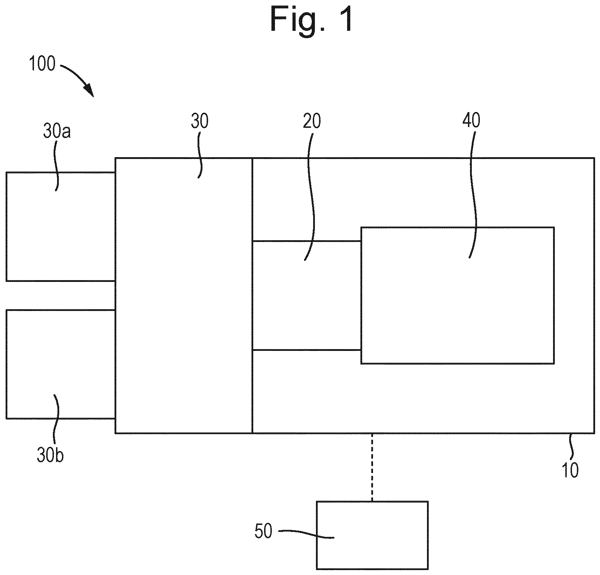

Reference is now made to **FIG. 1****,** which is a schematic diagram illustrating an exemplary charged particle beam inspection apparatus 100, which may also be referred to as a charged particle beam assessment system or simply assessment system. The charged particle beam inspection apparatus 100 of **FIG. 1** includes a main chamber 10, a load lock chamber 20, an electron-optical apparatus 40, an equipment front end module (EFEM) 30 and a controller 50. The controller may be distributed between different components of the assessment system, including for example in the electron-optical apparatus 40. The electron-optical apparatus 40 is located within main chamber 10.

EFEM 30 includes a first loading port 30a and a second loading port 30b. EFEM 30 may include additional loading port(s). First loading port 30a and second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in EFEM 30 transport the samples to load lock chamber 20.

Load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from load lock chamber 20 to main chamber 10. Main chamber 10 is connected to a main chamber vacuum pump system (not shown). The main chamber vacuum pump system removes gas particles in main chamber 10 so that the pressure in around the sample reaches a second pressure lower than the first pressure. After reaching the second pressure, the sample is transported to the electron beam apparatus by which it may be inspected. An electron-optical apparatus 40 may be a multi-beam electron-optical apparatus.

Controller 50 is signally, for example electronically, connected to electron-optical apparatus 40, for example as distributed components of the controller 50. Controller 50 may be a processor (such as a computer) configured to control the charged particle beam inspection apparatus 100. Controller 50 may also include a processing circuitry configured to execute various signal and image processing functions. While controller 50 is shown in **FIG. 1** as being outside of the structure that includes main chamber 10, load lock chamber 20, and EFEM 30, it is appreciated that controller 50 may be part of the structure. The controller 50 may be located in one of the component elements of the charged particle beam inspection apparatus or it can be distributed over at least two of the component elements. While the present disclosure provides examples of main chamber 10 housing an electron beam inspection apparatus, it should be noted that aspects of the disclosure in their broadest sense are not limited to a chamber housing an electron beam inspection apparatus. Rather, it is appreciated that the foregoing principles may also be applied to other systems and other arrangements of apparatus, that operate under the second pressure.

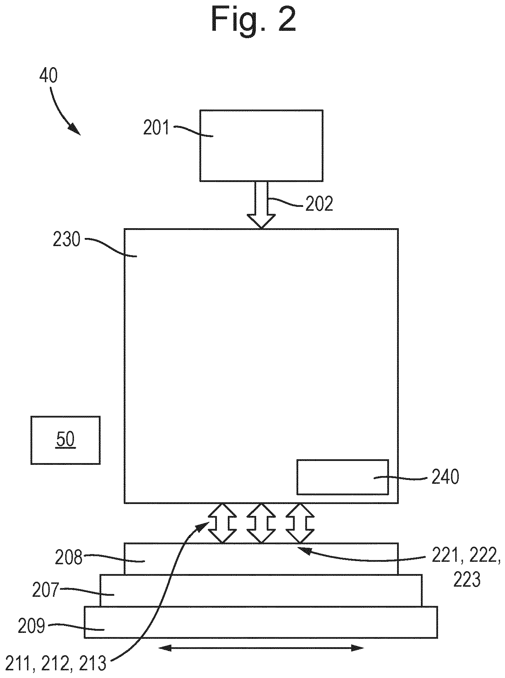

Reference is now made to **FIG. 2****,** which is a schematic diagram illustrating an exemplary electron-optical apparatus 40. The electron-optical apparatus 40 may be provided as part of the exemplary charged particle beam inspection system 100 of **FIG. 1****.** The electron-optical apparatus 40 includes an electron source 201 and an electron-optical column (or device) 230. (In a different arrangement the electron-optical column comprises the electron source 201.) The electron-optical column230 may be referred to or comprise a projection apparatus for directing a primary charged particle beam 202 towards a sample 208. The electron source 201 and associated and component charged particle-optical elements may be referred to as an illumination apparatus for generating a primary charged particle beam 202. The assessment apparatus comprises a sample support that supports a sample 208. The sample support in this example comprises a sample holder 207. The sample holder 207 holds the sample 208 (e.g., a substrate or a mask) for assessment. The sample holder 207 is supported by a motorized or actuated stage 209. The electron-optical apparatus 40 further comprises a detector 240. The detector 240 detects signal electrons from the sample 208. The detector 240 generates detection signals on detection of the signal electrons.

The electron source 201 may comprise a cathode (not shown) and an extractor or anode (not shown). During operation, electron source 201 is configured to emit electrons as primary electrons from the cathode. The primary electrons are extracted or accelerated by the extractor and/or the anode to form the primary electron beam 202.

The electron-optical column 230 is configured to convert primary electron beam 202 into a plurality of charged particle beams 211, 212, 213 and to direct each beam onto the sample 208. Although three beams are illustrated for simplicity, there may be many tens, many hundreds, many thousands, many tens of thousands, or even hundreds of thousands (or more) of beams. The beams may be referred to as beamlets or sub-beams. The plurality of charged particle beams may be referred to collectively as a multi-beam or beam grid. A beam grid with so many beams (e.g. more than a thousand beams) may have a field of view of e.g. more than 0.5mm, for example in the range of 0.5 to 30mm or 1 to 30 mm.

The controller 50 (for example control system comprising distributed controllers) may be connected to various parts of charged particle beam inspection apparatus 100 of **FIG. 1****,** such as the electron source 201, the detector 240, the electron-optical column 230, and actuated stage 209. The controller 50 may perform various image and signal processing functions. The controller 50 may also generate various control signals to govern operations of the charged particle beam inspection apparatus 100, including operations of the electron-optical apparatus 40.

The electron-optical column 230 may be configured to focus, for example, beams 211, 212, and 213 onto a sample 208 for inspection and may form three probe spots 221, 222, and 223 on the surface of sample 208. The electron-optical column 230 may be configured to deflect primary beams 211, 212, and 213 to scan probe spots 221, 222, and 223 across individual scanning areas in a section of the surface of sample 208. In response to incidence of primary beams 211, 212, and 213 on probe spots 221, 222, and 223 on sample 208, electrons are generated from the sample 208 which include secondary electrons and backscattered electrons which may be referred to as signal charged particles. The secondary electrons typically have electron energy as large as fifty electron volts (< 50 eV) and backscattered electrons typically have electron energy between fifty electron volts (50 eV) and the landing energy of primary beams 211, 212, and 213.

The detector 240 may send the detection signals generated in the detector 240, for example as an imaging or detection signal, to the controller 50 or a signal processing system (not shown which may be part of the controller 50), e.g. to construct images of the corresponding scanned areas of sample 208. The detector 240 may be incorporated at least partly into the charged particle device 230 or may be separate therefrom, for example where a secondary optical column directs secondary electrons to the detector 240.

The controller 50 may comprise an image processing system that includes an image acquirer (not shown) and a storage device (not shown). For example, the controller may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to the detector 240 permitting signal communication, such as an electrical conductor, optical fiber cable, portable storage media, IR, Bluetooth, internet, wireless network, wireless radio, among others, or a combination thereof. The image acquirer may receive the detection signal from the detector 240, may process the data comprised in the signal and may construct an image therefrom. The image acquirer may thus acquire images of sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The image acquirer may acquire one or more images of a sample 208 based on an imaging signal received from the detector 240. An imaging signal may correspond to a scanning operation for conducting charged particle imaging. An acquired image may be a single image comprising a plurality of imaging areas. The single image may be stored in the storage. The single image may be an original image that may be divided into a plurality of regions. Each of the regions may comprise one imaging area containing a feature of sample 208. The acquired images may comprise multiple images of a single imaging area of sample 208 sampled multiple times over a time period. The multiple images may be stored in the storage. The controller 50 may be configured to perform image processing steps with the multiple images of the same location of sample 208.

The controller 50 may include measurement circuitry (e.g., analog-to-digital converters) to obtain a distribution of the detected secondary electrons. A part of the controller for such a function may be comprised in or proximate to the detector. The electron distribution data, collected during a detection time window, can be used in combination with corresponding scan path data of each of primary beams 211, 212, and 213 incident on the sample surface to reconstruct images of the sample structures under inspection. The reconstructed images can be used to reveal various features of the internal or external structures of sample 208. The reconstructed images can thereby be used to reveal any defects that may exist in and/or on, thus of the sample.

The controller 50 may control actuated stage 209 to move sample 208 during inspection of sample 208, for example to provide a scanning motion of the stage relative to the paths of the primary beams. The controller 50 may enable actuated stage 209 to move sample 208 in a direction such as part of the scanning motion of the stage, preferably continuously, for example at a constant speed, at least during sample inspection. The controller 50 may control movement of the actuated stage 209 so that it changes the speed of the movement of the sample 208 dependent on various parameters. For example, the controller may control the stage speed (including its direction) depending on the characteristics of the inspection steps and/or scans of the scanning process for example as disclosed in WO 2022128392 A1 which is hereby incorporated by reference in so far as the combined stepping and scanning strategy at least of the stage. In controlling the actuated stage, actuation of the stage and thus the sample may enable the sample to be positioned, for example dynamically, relative to the paths of the primary beams.

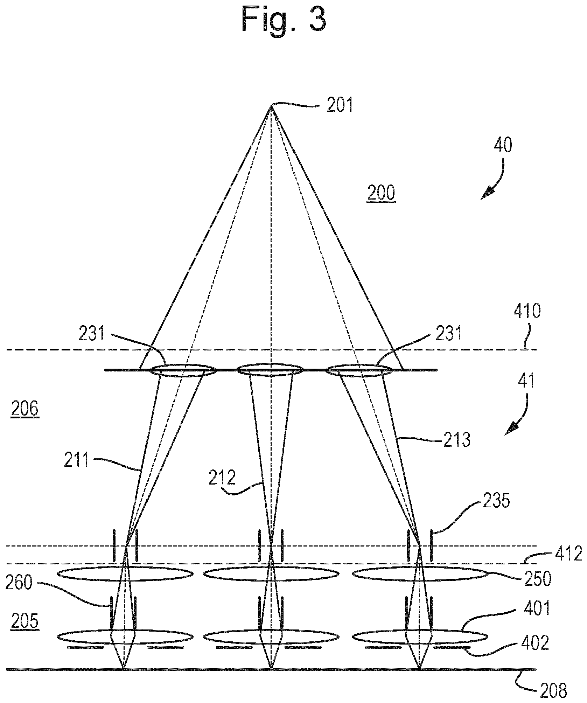

**FIG. 3** is a schematic diagram of an exemplary electron-optical apparatus 40 for use in an assessment apparatus. The electron-optical apparatus 40 comprises a electron-optical device 41 configured to project charged particles towards the sample 208. Such an electron-optical device comprises all electron-optical elements that are intended to operate on electrons between the source and sample. In the depicted arrangement all electron-optical elements are electrostatic; in a different arrangement one or more of the electron-optical elements may be magnetic. For ease of illustration, lens arrays are depicted schematically herein by arrays of oval shapes. Each oval shape represents one of the lenses in the lens array. The oval shape is used by convention to represent a lens, by analogy to the biconvex form often adopted in optical lenses. In the context of electron-optical devices such as those discussed herein, it will be understood that lens arrays will typically operate electrostatically and so may not require any physical elements adopting a biconvex shape. As described below, lens arrays may instead comprise multiple plates with apertures. Each plate with apertures may be referred to as an electrode. The electrodes may be provided in series along a path of a beam grid of a plurality of charged particle beams (which may also be referred to as sub-beams). The electrodes are thus also in series along paths of charged particle beams of the beam grid.

Electron source 201 directs electrons toward an array of condenser lenses 231 (as a condenser lens array) forming part of electron-optical device 41. The electron source 201 is desirably a high brightness thermal field emitter with a good compromise between brightness and total emission current. There may be many tens, many hundreds or many thousands or even tens of thousands of condenser lenses 231. Condenser lenses 231 may comprise multi-electrode lenses and have a construction based on EP1602121A1, which document is hereby incorporated by reference in particular to the disclosure of a lens array to split an e-beam into a plurality of sub-beams, with the array providing a lens for each sub-beam. The condenser lens array may take the form of at least two, preferably three, plates, acting as electrodes, with apertures in each plate aligned with apertures in other plates to define paths for charged particle beams through the plates.

Each condenser lens in the array directs electrons into a respective beam 211, 212, 213 which is focused at a respective intermediate focus 233. A collimator or an array of collimators may be positioned to operate on the respective intermediate focuses 233. The collimators may take the form of deflectors 235 provided at the intermediate focuses 233. The collimators are configured to bend a respective beam 211, 212, 213 by an amount effective to ensure that the principal ray (which may also be referred to as the beam axis) is incident on the sample 208 substantially normally (i.e. at substantially 90° to the nominal surface of the sample). Note that in an arrangement with a macro condenser lens, the condenser lens may collimate or contribute to the collimation of the source beam or, in an embodiment, a plurality of beams.

An objective lens array 401 is provided downbeam from the collimators. The objective lens array 501 comprises an objective lens for each beam 211, 212, 213. The objective lens array 401 projects the beams 211, 212, 213 onto the sample 208. The objective lens array 401 may comprise two or more, preferably at least three, plate electrode arrays connected to respective potential sources.

Optionally, a control lens array 250 is provided between the collimators and the objective lens array 401. The control lens array 250 comprises a control lens for each beam 211, 212, 213. The control lens array 250 provides additional degrees of freedom for controlling properties of the beams 211, 212, 213. The control lens array 250 may comprise two or more, preferably at least three, plate electrode arrays connected to respective potential sources. A function of control lens array 250 is to optimize the beam opening angle with respect to the demagnification of the beam and/or to control the beam energy delivered to the objective lenses, each of which directs a respective beam 211, 212, 213 onto the sample 208. In an embodiment the control lens array may be considered to be part of the objective lens, for example in being additional plates associated with the objective lens array.

Optionally an array of scan deflectors 260 is provided between the control lens array 250 and the objective lens array 401. The array of scan deflectors 260 comprises a scan deflector for each beam 211, 212, 213. Each scan deflector is configured to deflect a respective beam 211, 212, 213 in one or two directions to scan the beam across the sample 208 in one or two directions. Alternatively, a macro scan deflector may be provided to scan the charged particle beams over the sample 208. The macro scan deflector may be provided upbeam of the control lens array 250. In an embodiment such a macro scan deflector may operate on the source beam and may be present with a macro condenser lens.

A detector module 402 of a detector is provided within the objective lenses or between the objective lenses and the sample 208 to detect signal electrons/particles from the sample 208. An exemplary construction of such a detector module 402 is described below. Note that the detector additionally or alternatively may have detector elements upbeam along the beam path of the objective lens array 401 or even the control lens array 250. The detector module may be an array of detector elements (e.g. a detector array). Each element may be associated with an individual beam, for example positioned to detect signal particles generated by the individual beam.

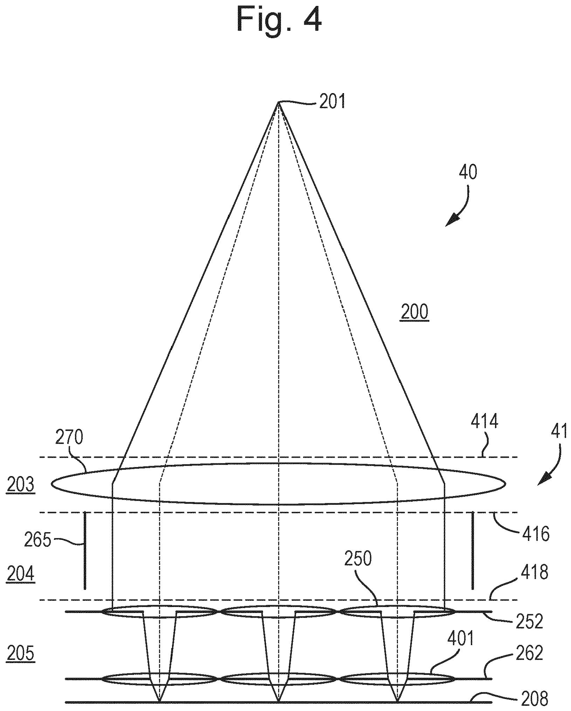

**FIG. 4** depicts a variation on the arrangement of **FIG. 3** in which the electron-optical apparatus 40 comprises a macro collimator 270 and a macro scan deflector 265 instead of the condenser lenses 231 and deflectors 235 of **FIG. 3****.** Features that are the same as those described above are given the same reference numerals. For conciseness, such features are not described in detail with reference to **FIG. 4****.** For example, the source 201, the control lens array 250, the objective lens array 401 and the sample 208 may be as described above. The macro collimator 270 and/or the macro scan deflector 265 may be a macro lens that may be magnetic, electrostatic or both. The macro collimator 270 and the macro scan deflector 265 act on the beam before the beam is split to form the multi-beam. The macro collimator 270 and the macro scan deflector 265 may thus act on all of the beam rather than comprising arrays of elements configured to interact with different individual portions of the beam.

In the arrangement of **FIG. 4****,** a beam from the source 201 is split into multiple beams by a sub-beam forming array 252 defining an array of beam-limiting apertures. The objective lens array assembly in this embodiment further comprises a beam shaping aperture array 262 downbeam from the sub-beam forming array 252. The beam shaping aperture array 262 defines an array of beam-limiting apertures. The beam shaping aperture array 262 may shape beams defined by the sub-beam forming array 252. The use of two shaping aperture arrays is beneficial in situations in which use of only the sub-beam forming array 252 risks introducing aberrations into the beams. In a variation of the arrangement shown in and described with reference to **FIG. 4****,** the macro scan deflector may be replaced with a scan deflector array associated with the objective lens array and/or the macro condenser lens may be replaced with a collimator deflector array associated with the control lens array and/or the sub-beam forming array 252.

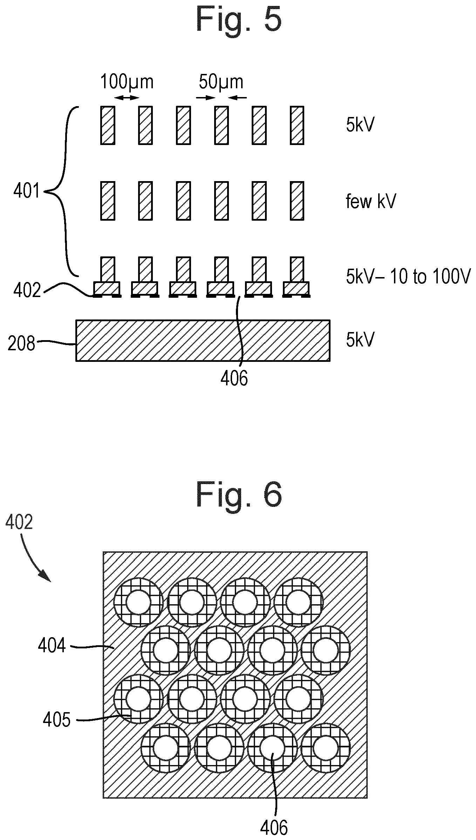

In some embodiments, the objective lens array assembly comprises a detector having a detector module 402 downbeam of at least one electrode of the objective lens array 401. The detector module 402 may comprise or even take the form of a detector array. An exemplary embodiment of a detector integrated into an objective lens array 401 is shown in **FIG. 5****,** which illustrates a portion of an objective lens array 401 in schematic cross section. In this embodiment, the detector comprises a detector module 402 comprising a plurality (e.g., an array) of detector elements 405 (shown in **FIG. 6**), for example sensor elements such as capture electrodes, preferably as an array of detector elements (i.e. a plurality of detector elements in a pattern or arrangement preferably over a two dimensional surface). In this embodiment, the detector module 402 is provided on an output side of the objective lens array. The output side is the output side of the objective lens array 401. **FIG. 6** is a bottom view of detector module 402 which comprises a substrate 404 on which are provided a plurality of detector elements (or capture electrodes 405) each surrounding a beam aperture 406. The beam apertures 406 may be formed by etching through substrate 404. In the arrangement shown in **FIG. 6****,** the beam apertures 406 are shown in a hexagonal close packed array. The beam apertures 406 can also be differently arranged, e.g. in a rectangular array.

An electric power source may be provided to supply electrical power to the different electron-optical components of the electron-optical device 41. For example the electric power source may apply respective potentials to electrodes of for example the control lenses of the control lens array 250 and the objective lenses of the objective lens array 401 and the condenser lenses of the condenser lens array or any electron-optical component of the electron-optical device 41 for example the detector module (such as when integrated into the objective lens array or when the objective lens and detector module are separate components). A controller 50 may control the potentials applied to the electron-optical components such as the electrodes of the condenser lens array, objective lens array and/or control lens array.

The electron-optical device 41 may comprise other electron-optical components such as charged particle correctors, for example as corrector arrays for alignment of the source to the sample and between beams of the multi-beam and for adjusting the focus of different groups of the beam grid, or individual beams of the beam grid. Such correctors may be controlled to operate dynamically and/or statically, for example during step-up, servicing or during calibration of the electron-optical device 41.

In an embodiment, an array of electron-optical devices (or device array) is provided. The array may comprise a plurality of any of the electron-optical devices (e.g., electron-optical columns) described herein. Each of the electron-optical devices in the array focuses respective pluralities of charged particle beams onto different regions of the same sample 208. Each charged particle device in the array may derive a respective plurality of charged particle beams from a different respective source 201. Each respective source 201 may be one source in a plurality of sources 201. At least a subset of the plurality of sources 201 may be provided as a source array. The source array may comprise a plurality of emitters on a common substrate. The focusing of pluralities of charged particle beams from different charged particle devices simultaneously onto different regions of the same sample allows an increased area of the sample 208 to be exposed to charged particle beams simultaneously. Therefore, an increased area of the sample may be processed (e.g. assessed) at one time. The charged particle devices in the device array may be arranged adjacent to each other so as to project the respective pluralities of beams onto adjacent regions of the sample 208. Any number of charged particle devices may be used in the array. Preferably, the number of charged particle devices is in the range of 9 to 200. Each charged particle device in the array may be configured in any of the ways described herein when referring to a single charged particle device, electron-optical device or system or column. Alternatively or additionally, one or more of the charged particle device in the array may be configured to project a single beam.

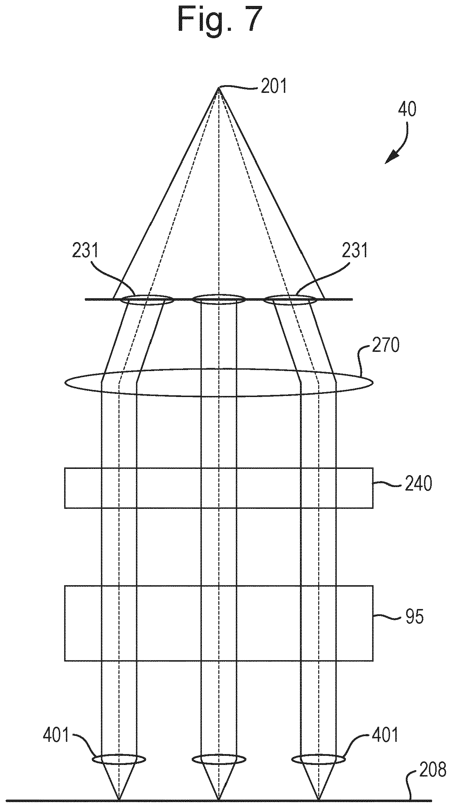

**FIG. 7** schematically depicts a further example of a electron-optical apparatus 40 having a charged particle device 41. Features that are the same as those described above are given the same reference numerals. For conciseness, such features are not described in detail with reference to **FIG. 7****.** For example, the source 201, the condenser lenses 231, the objective lens array 401 and the sample 208 (e.g., on a sample support 207) may be as described above. In another arrangement the condenser lens 231 may be an *'aperture lens'.* The aperture lens may comprise a macro lens element and a beam limiting aperture array to generate the sub-beams. The macro lens element may be positioned upbeam of the beam limiting aperture array. The aperture lens may operate to focus the sub-beams into an intermediate focus plane. In this example, a macro collimator 270 is provided instead of a deflector array of the type described above with reference to **FIG. 3****.** Such a macro collimator may be a macro lens that may be magnetic, electrostatic or both. In other embodiments, a deflector array may be used to at least contribute to the collimation of the beams, so the deflector array is for finer deflection towards collimation than the action of the macro collimator 270. Such an arrangement may also comprise an array of multiple deflectors (for example in which each aperture has multiple electrodes) for even finer collimation. In an arrangement the condenser lenses 231 may comprise a single plate defining a beam limiting aperture array in which are defined a plurality of apertures with one or more associated macro electrodes with a single aperture. Such a beam limiting aperture array and an associated macro electrode may also form a condenser lens array to focus the generated beams in an intermediate focus which desirably corresponds to the position of the collimator 270.

As described above, in some embodiments a detector may be provided between the objective lens array 401 and the sample 208. The detector may face the sample 208. Alternatively, as shown in **FIG. 7****,** the detector 240 may be implemented such that the objective lens array 401 is between the detector 240 and the sample 208.

In an embodiment a deflector array 95 is provided between the detector 240 and the objective lens array 401. In an embodiment the deflector array 95 comprises a Wien filter array so that deflector array 95 may be referred to as a beam separator. The deflector array 95 is configured to provide a magnetic field and an electrostatic filed. The electrostatic and magnetic fields operate together to separate the electrons projected to the sample 208 relative to the signal electrons from the sample 208. The operation of the fields directs the signal electrons towards the detector 240.

In an embodiment the detector 240 is configured to detect signal electrons by reference to the energy of the charged particle, i.e. dependent on a band gap, such as a semiconductor-based type of detector. Such a detector 240 may be called an indirect current detector. The secondary electrons emitted from the sample 208 gain energy from the fields between the electrodes. The secondary electrons have sufficient energy once they reach the detector 240. In a different arrangement the detector 240 may be an electron to photon converter such as a scintillator array, for example of fluorescing strip between the beams that are positioned upbeam along the beam path with respect to the Wien filter. Primary beams passing through the Wien filter array (of magnetic and electrostatic strips orthogonal to the beam path) have paths upbeam and downbeam of the Wien filter array that are substantially parallel, whereas signal electrons from the sample are directed by the Wien filter array towards the scintillator array. The electron to photon converter may be photonically coupled to a photon to electron converter to convert any photons generated in and emitted by the electron to photon converter. The photon to electron converter may be electrically connected to electronic circuitry to process a detection signal. In different embodiments the photon to electron converter may be within or external to the charged particle device. In an embodiment photon coupling may be by via a photon transport unit (e.g., an array of optical fibers) to a remote optical detector which generates a detection signal on detection of a photon.

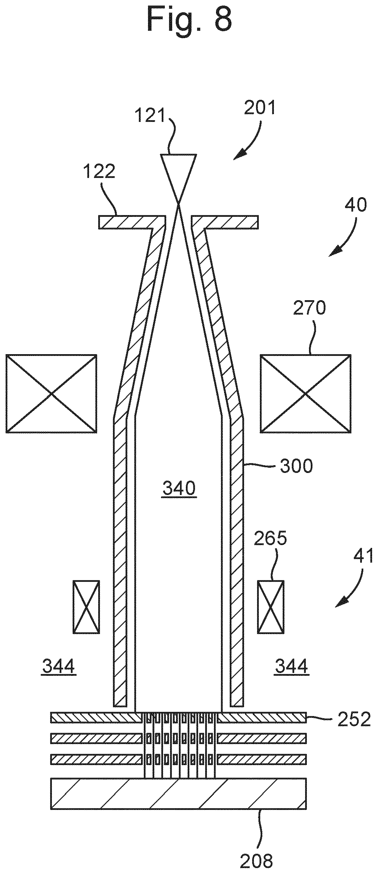

As shown in **FIG. 8****,** in an embodiment the electron-optical apparatus 40 comprises a beam tube 300 (which may also be called a tube, liner tube, or booster tube). In an embodiment the beam tube 300 is arranged to surround the path of the beam grid. The beam tube 300 surrounds the paths of electrons. The electrons may be a source beam emitted from the source 121 towards a sample. The electrons may be of a plurality of beams of the beam grid. The beam tube 300 may surround the path of the source beam or the path of the beam grid for example when viewed along the primary axis of the electron-optical apparatus 40, i.e. in the direction of the charged particle beam. In an embodiment the beam tube 300 is configured to surround only part of the path, i.e. part of the path along the length of the path for example a length along part of the path. For example, as shown in **FIG. 8****,** in an embodiment the beam tube 300 surrounds the part of the path of the source beam from the source 201 to just above the sub-beam forming array 252. In other embodiments, the beam tube 300 surrounds different portions, e.g. lengths, of the path of the beam grid.

In an embodiment the beam tube 300 is configured to operate at a first potential difference from ground. A support may be configured to support the sample 208 at a second potential difference from ground or at ground. The first potential difference may be greater than the second potential difference and such as to accelerate the electrons of the multi-beam towards the sample 208. Arranging for the potential difference between the sample and the immediate environment to be relatively low may reduce the possibility of electrical breakdown in the vicinity of the sample 208. This can reduce the possibility of the sample 208 being damaged. The risk of damage to components of the charged particle device 41 such as the detector 240 (which may feature delicate electronic elements) may be reduced.

As explained above and exemplified in **FIG. 8****,** the electron source 201 may comprise a cathode 121 and an anode 122 (which may also be called an extractor or an extractor electrode). The cathode 121 and the anode 122 are configured to operate with a potential difference between them. The cathode 121 is configured to emit the charged particle beam. The anode 122 is configured to accelerate the charged particle beam towards the sample 208. Note, this source arrangement is a simplified arrangement. The source 201 may have a different arrangement and other electrodes, so long as the source 201 has a most downbeam source electrode, which is here referred to as the anode 122.

As shown in **FIG. 8****,** in an embodiment the beam tube 300 is electrically connected to the anode 122. By electrically connecting the beam tube 300 to the anode 122, there is no electric field formed between the source 201 and the beam tube 300. Any unwanted lensing effect upbeam of the beam tube 300 is avoided. The beam tube 300 may be formed together with the anode 122. The beam tube 300 and the anode 122 may be integral. Alternatively, the beam tube 300 may be separated from the source 201. The beam tube 300 may be distanced along the axial direction from the anode 122.

As shown in **FIG. 8****,** in an embodiment at least part of the charged particle device 41 is downbeam of the most downbeam end of the beam tube 300. For example, the sub-beam forming array 252, the control lens array 250, the objective lens array 241 and the beam shaping aperture array 262 may be provided downbeam of the beam tube 300. In an embodiment, the part of the charged particle device 41 downbeam from the beam tube 300 may be configured to decelerate the charged particle beam. The part of the charged particle device 41 downbeam from the beam tube 300 may be referred to as a charged particle-optical element.

In an embodiment, the electron-optical apparatus 40 is configured such that the charged particle beam passes through the electron-optical apparatus 40 without undesirable lensing effects being applied to the beam. The downbeam end of the beam tube 300 may be configured to be in a region that has a small electric field or no electric field. This can help reduce or avoid any lensing effect on the charged particle beam that could be caused by an electric field between the beam tube 300 and any parts of the charged particle device 41 downbeam of the beam tube 300.

As shown in **FIG. 8****,** in an embodiment the beam tube 300 is spaced apart from the part of the charged particle device 41 downbeam of the beam tube 300. The separation may make it easier to manufacture the electron-optical apparatus (by easing tolerances) and/or to replace part or all of the charged particle device 41. In an embodiment the separation is at most 1mm. Any electric field between the beam tube 300 and any part of the charged particle device 41 downbeam of the beam tube 300 may be confined to a small distance as a gap. This arrangement may help to reduce or even prevent the effect of any electric field between the beam tube 300 and a part of the charged particle device downbeam of the beam tube 300 (or downbeam part). In such an arrangement the beam tube 300 and the downbeam part may be set to the same potential. In a different arrangement the beam tube 300 and the downbeam part may be set to different potential so as to achieve a lensing effect on the multi-beam path between an end of the beam tube 300 and the downbeam part. In an embodiment, the small gap may also suppress ingress of fluid into the beam tube through the gap between an end of the beam tube and the downbeam part. In an alternative embodiment the beam tube 300 is electrically connected to the part of the charged particle device 41 that is downbeam of the beam tube 300. For example, the beam tube 300 may be structurally connected to and/or integral with the associated plate, for example the sub-beam forming array 252.

In the example of **FIG. 8****,** a macro collimator 270 comprising a magnetic component is provided, for example as part the charged particle device 41. The magnetic component can influence trajectories of electrons within the beam tube 300 while being located outside of the beam tube 300.

In an alternative embodiment the macro collimator 270 comprises an electrostatic component. Such an electrostatic component may be affected by the beam tube 300, for example its shielding of electrostatic fields external to the beam tube 300. In an embodiment the electrostatic component of the macro collimator 270 is located within the beam tube 300 (not shown) or between lengths or sections of the beam tube (see WO 2023046440 A1, hereby incorporated by reference at least so far as designs comprising electron-optical elements and a beam tube and its sections).

In an embodiment the charged particle device 41 comprises a macro scan deflector 265. The macro scan deflector 265 is configured to deflect respective portions of the charged particle beam. The respective portions correspond to different sub-beams further downbeam. Deflection of the portions by the macro scan deflector 265 thus causes deflection of the respective beams of electrons, in the multi-beam, to be scanned relative to, for example over, the sample 208. As shown in **FIG. 8** in an embodiment the macro scan deflector 265 is upbeam of the downbeam end of the beam tube 300.

As shown in **FIG. 8****,** in an embodiment the macro scan deflector 265 comprises a magnetic deflector. The macro scan deflector 265 may be located outside of the beam tube 300.

In an alternative embodiment a scan deflector comprising an array of deflectors may be provided instead of a macro scan deflector. Such an array of deflectors is provided within the charged particle device 41 as an array of scan deflectors 260 as depicted in **FIG. 3****.** Such an array of scan deflectors may be associated with an objective lens array, for example in which a deflector of the array is associated with each beam of the multi-beam.

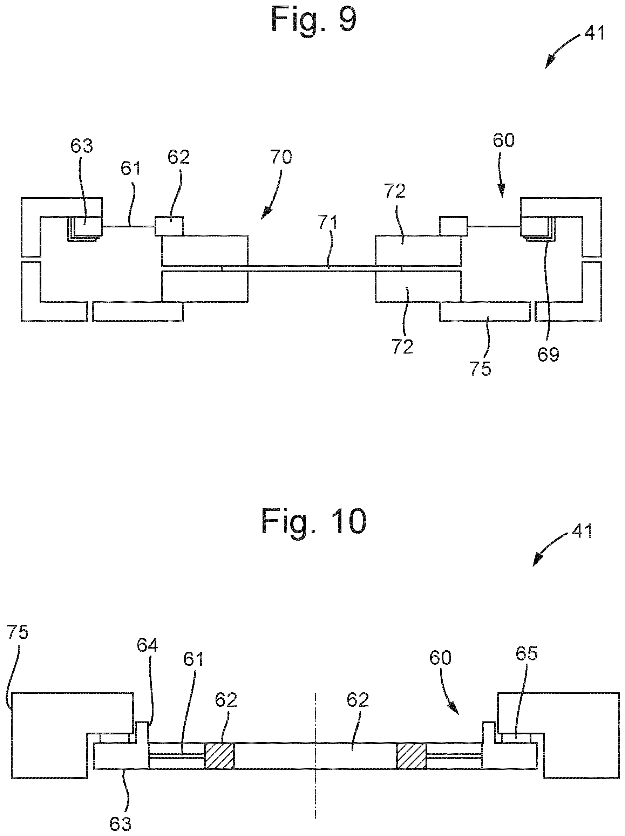

In the embodiment shown in **FIG. 8****,** the beam tube 300 extends continuously from a position close to the sub-beam forming array 252 to the source 122. When the beam tube 300 is metallic (or is coated with a metallic material) this will shield the interior of the beam tube 300 from electrostatic fields generated outside of the beam tube 300. As explained above, elements may be provided for manipulating charged particle trajectories within the beam tube 300 either via magnetic fields generated outside of the beam tube 300 or via magnetic or electrostatic fields generated within the beam tube 300. A further possibility, not shown, is to provide gaps in the beam tube 300 to allow electric fields generated outside of the beam tube to influence charged particle trajectories within the beam tube 300. Although the depiction and description of the beam tube and its position, configuration and use is as shown in and described with reference to **FIG. 8** which relates to the electron-optical device 41 of the electron-optical apparatus 40 shown in and described with reference to **FIG. 4****,** a beam tube may be applied in electron-optical devices 41 of any of the electron-optical apparatuses 40 shown in and described with reference to **FIG. 4** and **FIG. 7****,** for example. **FIG. 9** is a schematic cross-sectional view of a portion of an electron-optical device 41. The electron-optical device 41 is for projecting one or more beams of electrons towards a sample location. The electron-optical device 41 may be part of an electron-optical apparatus 40, for example as described with reference to **FIG. 2****,** **FIG. 3****,** **FIG. 4****,** **FIG. 7** or **FIG. 8****.** The electron-optical device 41 may have features as described elsewhere with reference to **FIG. 3****,** **FIG. 4** or **FIG. 8****,** for example.

As shown in **FIG. 9****,** in an embodiment the electron-optical device 41 comprises an assembly 70. As shown in **FIG. 9****,** the assembly 70 comprises at least one electron-optical element 71. The electron-optical element 71 is configured to direct one or more beams of electrons along a path (which, mentioned earlier herein, may be referred to as a beam path) towards the sample location.

In the arrangement shown in **FIG. 9****,** the assembly 70 comprises only one electron-optical element 71. In an alternative embodiment, the assembly 70 comprises a plurality of electron-optical elements. For example, the assembly 70 may comprise a stack of electron-optical elements 71. Thus the assembly 70 may comprise any feature which may be expected to be found in a stack such as: the electron-optical element 71, a detector which may take the form of a plate, a support for example to space between adjoining plates and have similar topological and geometrical features to an electron-optical element; a thermal conduit for thermal control of the stack and other features for shielding between the stack and surrounding components of the electron-optical device 41 and the stack and electrically connecting elements within the stack.

In an embodiment each electron-optical element 71 comprises a plate in which is defined one or more beam apertures. Each beam aperture is for the passage of one or more beams of electrons. When a stack of electron-optical elements is provided, the beam apertures of the electron-optical elements 71 may be aligned with each other. However, it is not essential for the electron-optical element 71 to be plate-like. The electron-optical element 71 may comprise electrodes to which electric potentials are applied so as to generate electric fields that manipulate the electrons.

As shown in **FIG. 9****,** in an embodiment the electron-optical device 41 comprises a frame 75, which may be referred to as a mechanical frame. The frame 75 may be part of the frame of the electron-optical device. The frame 75 may comprise or be connected to the chamber wall of the electron-optical device, such as a part or section of the chamber wall. The chamber wall may define the extent of a region which may have desired pressure such as a vacuum. The electron-optical apparatus may comprise vacuum chambers comprising different regions and configured to be at respective vacuums. In an embodiment the seal 60 defines a part of a wall between different regions. The frame 75 may comprise a wall of the one or more vacuum chambers. Additionally or alternatively, a part of the assembly 70 may comprise a wall of one or more of the vacuum chambers. In an embodiment the frame 75 is around the beam path. The frame 75 extends circumferentially around the beam path. When viewed along the electron-optical axis (i.e. along the beam path), the frame 75 may surround the beam path. The frame 75 may define an aperture upbeam of the assembly 70 and/or downbeam of the assembly 70. The aperture may be for the passage of the beam paths.

As shown in **FIG. 9****,** in an embodiment the frame 75 is connected to the assembly 70. For example, as shown in **FIG. 9** in an embodiment the frame 75 comprises a portion (shown at the bottom of **FIG. 9**) that is connected to the assembly 70. In an embodiment the frame 75 is secured to the assembly 70. In an embodiment the frame 75 is secured to the assembly 70 by a fixing configured to fix the mechanical frame 75 to the assembly 70. In an embodiment the fixing comprises an adhesive. Alternatively, the fixing may comprise a mechanical connector such as a bolt, a screw or a clamp, for example. By providing a mechanical connector such as a bolt, screw or clamp, the possibility of undesirable outgassing from an adhesive may be reduced.

In an embodiment a method of manufacturing the electron-optical device comprises a step of aligning the assembly 70 with the frame 75. In an embodiment the assembly 70 is moved relative to the frame 75 in at least one degree of freedom, for example so as to align with the frame 75. In an embodiment the assembly 70 may be moveable relative to the frame 75 in a plurality of degrees of freedom, for example at least three degrees of freedom and optionally in six degrees of freedom. In an alternative embodiment the frame 75 is moved relative to the assembly 70. In any event, alignment of the frame 75 and the assembly 70 requires relative movement between the frame 75 and the assembly 70. In an embodiment it is determined that the assembly 70 is sufficiently aligned with the frame 75. The frame 75 is then connected to the assembly 70. (That is the frame and the assembly are secured, for example connected, to each other). In an embodiment the frame 75 has a fixed location relative to the assembly 70. That is, the frame and the assembly have a fixed location with respect to each other. The frame 75 may be secured to the assembly within the electron-optical device 41, for example at one end of the electron-optical device 41. For example the frame may be part of a section of the electron-optical device 41 for example an upbeam end or a downbeam end of the electron-optical device 41.

As shown in **FIG. 9****,** in an embodiment the electron-optical device 41 comprises a seal 60. As shown in **FIG. 9****,** in an embodiment the seal is around the beam path. The seal 60 may extend around the periphery, e,g. circumference of the beam path. The seal 60 may surround the beam path when viewed along the beam path. In the seal 60 may be defined an aperture for the passage of the one or more beams. The aperture may be defined in the center of the seal. The seal 60 may be configured to allow passage of the one or more beams. The seal may be positioned in use for the passage of one more beam paths. The seal 60 may be configured to maintain properties of the one or more beams when the one or more beams pass through the aperture for example from upbeam of the seal 60 to downbeam of the seal 60.

As shown in **FIG. 9****,** in an embodiment the seal 60 is secured between the frame 75 and the assembly 70. The seal may be substantially planar, for example in a plane. As shown in **FIG. 9****,** in an embodiment the seal 60 is secured directly to the frame 75. In an alternative embodiment, the seal 60 is secured to the frame 75 via an intermediate component. For example, the seal 60 may be secured to the intermediate component and the frame 75 may be secured to the intermediate component. In an embodiment a plurality of intermediate components may be provided for securing the seal 60 to the frame 75. As shown in **FIG. 9****,** in an embodiment the seal 60 is secured directly to the assembly 70. In an alternative embodiment the seal 60 is secured to the assembly 70 via one or more intermediate components.

In an embodiment the seal defines a part of a wall between different regions. By securing the seal 60 between the frame 75 and the assembly 70, the possibility of fluid comprising gas molecules (e.g. water and hydrocarbon molecules which may be a product of outgassing) and atoms, passing between different regions either side of the seal is reduced if not prevented by the seal. The chance of such fluid flowing between regions either side of the seal that have different local environments may be reduced if not prevented. The different regions may have different pressures. For example fluid flowing from a region of the electron-optical device 41 on one side of the seal to another region maintained at a different pressure (i.e. the other side of the seal) may be reduced. For example, the possibility of fluid flowing between the seal 60 and the assembly 70 may be reduced if not prevented. The possibility of fluid flowing between regions depicted above and below both the seal 60 and the frame 75 may be reduced if not prevented. An embodiment of the invention is expected to reduce undesirable particle flow. Alternatively or additionally an embodiment of the invention seeks to maintain the pressure differential between regions either side of the seal. The seal may be sealed to the frame 75 and to the assembly 70. Such a sealed seal prevents any flow of fluid in a gap between the assembly and the frame. Having the seal sealed to the frame 75 and the assembly 70 may be practical when the frame 75 and the assembly 70 are part of the same section (or module) of the electron-optical apparatus 40. Such a seal would not interfere with replacement of the section such as in the field, for example if the seal were between two sections (or modules) of the electron-optical apparatus 40.

In an embodiment the seal 60 in use is configured to block fluid (e.g. gas molecules) from flowing through the seal. The seal blocks fluid from around (e.g. radially outward of) the assembly 70, for example through the material of the seal. Fluid, such as gas molecules which may contain particles particularly submicron particles may be present in a region downbeam of the seal and the assembly 70 such as from under and/or peripherally outward of the at least one electron-optical element 71. The seal 60 is arranged to reduce the possibility of fluid flowing through the seal 60 for example upbeam e.g. towards the source. As mentioned elsewhere, the electron-optical element 71 may comprise one or more apertures such as beam apertures which may be arranged in a pattern such as an array. Fluid may flow through the one or more apertures. By providing the seal 60 the fluid conductance in an upbeam direction, for example through the electron-optical device, may be reduced. The fluid conductance may not be reduced to zero because of the possibility of fluid flowing through the one or more apertures. In an embodiment there may be other types of apertures defined in the electron-optical elements for example dummy apertures to regulate the electric field generated towards the edges of the array for the beam paths.

In an embodiment the seal 60 is compliant in at least one degree of freedom between the frame 75 and the assembly 70. For example, in an embodiment the seal 60 is compliant in at least three degrees of freedom, for example about the axes of a plane across the beam path (and/or of the plane of the seal) and in a direction parallel to the beam path (and/or orthogonal to the plane of the seal). Having the seal 60 compliant may help reduce the risk that the seal 60 causes undesirable deformation and/or undesirable misalignment for example of the assembly with respect to the frame 75.

In an embodiment a method of manufacturing the electron-optical device 41 comprises a step of securing the seal 60 between the frame 75 and the assembly 70. The securing of the seal to the frame is sealed (or fluid tight). In an embodiment the seal 60 is secured between the frame 75 and the assembly 70 after the frame 75 has been connected to the assembly 70. The securing of the seal to the frame is sealed (or fluid tight). For example, in the arrangement shown in **FIG. 9****,** the connection between the frame 75 and the assembly 70 shown at the bottom of the drawing may be formed before the seal 60 is applied.

By providing that the seal 60 is compliant, the possibility of the seal 60 undesirably causing misalignment between the assembly 70 and the frame 75 is reduced. By providing that the seal 60 is compliant, the possibility of the seal 60 causing undesirable deformation of the assembly 70 and/or the frame 75 is reduced. An embodiment of the invention is expected to reduce undesirable fluid flow, for example through the seal, without unduly increasing the risk of misalignment and/or deformation.

If the seal 60 were not compliant (i.e. if the seal were rigid), then the application of the seal could undesirably cause movement and/or stress between the frame 75 and the assembly 70. Such forces may otherwise cause misalignment of the part of the electron-optical apparatus that is within the assembly with respect to the frame and a reference point of the electron-optical apparatus, such as the source. Such forces would otherwise risk misalignment of the components within the electron-optical device.

As shown in **FIG. 9****,** in an embodiment the seal 60 comprises a membrane 61. In an embodiment the membrane 61 is substantially planar. The membrane 61 is configured to block a flow of fluid from around the electron-optical element 71. In an embodiment the membrane 61 is compliant in at least one degree of freedom, for example in at least two degrees of freedom or in at least three degrees of freedom. As shown in **FIG. 9****,** in an embodiment the membrane 61 is oriented substantially across the beam path (i.e. perpendicular to the beam path). The membrane 61 may be compliant in a direction along the beam path (i.e. in the up/down direction in **FIG. 9**). In an embodiment the membrane 61 is compliant to rotation about at least one axis across the beam path. For example, the membrane 61 may be compliant to rotation about two perpendicular axes across the beam path. The membrane 61 may be compliant in three degrees of freedom when the seal 60 is secured between the frame 75 and the assembly 70.

In an embodiment a method of manufacturing the electron-optical device 41 comprises aligning the seal 60 with the frame 75 and/or the assembly 70. In an embodiment the seal 60 is aligned with the frame 75 and/or the assembly 70 before the seal 60 is secured between the frame 75 and the assembly 70. For example, in an embodiment the seal 60 is aligned with the frame 75 and/or the assembly 70 in at least one degree of freedom, optionally at least two degrees of freedom and optional at least three degrees of freedom. For example, in an embodiment the seal 60 is aligned with the frame 75 and/or the assembly 70 in at least one and optionally in two perpendicular directions across the beam path. The seal 60 may be aligned with the frame 75 and/or the assembly 70 with respect to rotation around an axis along the beam path.

In an embodiment the seal 60 is aligned with the frame 75 and/or the assembly 70 in at least one degree of freedom before the seal 60 is secured between the frame 75 and the assembly 70. When the seal 60 is secured between the frame 75 and the assembly 70, the seal 60 may be compliant in at least one further degree of freedom. For example, the seal 60 may be aligned in three degrees of freedom with respect to the frame 75 and/or the assembly 70 before the seal 60 is attached. After attachment of the seal 60, the seal 60 may be compliant in a further three degrees of freedom.

The examples of degrees of freedom provided above are only exemplary. In alternative embodiments, the seal 60 may be aligned in different degrees of freedom and may then be compliant in different degrees of freedom after attachment. For example, in an alternative arrangement the membrane 61 may be substantially cylindrical. For example the membrane 61 may be arranged to form a short cylinder extending along the beam path. Before attaching the seal 60, the seal 60 may be aligned with the frame 75 and/or the assembly 70 in a direction along the beam path and rotationally around the beam path. The membrane 61 may be compliant to movement along and rotation about axes across the beam path.

In an embodiment the seal 60 comprises a metal. In an embodiment the seal 60 comprises foil. For example, in an embodiment the membrane 61 comprises a metal such as a foil. By using metal, outgassing may be reduced, for example compared to using a polymer. By reducing outgassing, the possibility of undesirable contamination may be reduced.

A foil is a thin sheet of metal. By providing a foil, the foil may be compliant, thereby reducing the possibility of undesirable deformation or misalignment caused by the seal 60. In an embodiment the membrane 61 comprises a material selected from the group consisting of titanium and aluminium. Other metals in foil form may be used for the membrane 61. In an embodiment the membrane 61 comprises a non-magnetic metal such as aluminum or titanium. In an embodiment the membrane 61 comprises a vacuum-compatible metal.

In an embodiment the membrane 61 has a thickness of at most 100 µm, optionally at most 50 µm, optionally at most 20 µm and optionally at most 10 µm. By reducing the thickness of the membrane 61, the stiffness of the membrane 61 may be reduced. By reducing the stiffness of the membrane 61, the force exerted by the presence of the seal 60 on the assembly 70 and/or the mechanical frame 75 may be reduced. By reducing the force, the possibility of undesirable deformation and/or misalignment may be reduced.

In an embodiment the membrane 61 has a thickness of at least 1 µm, optionally at least 2 µm, optionally at least 5 µm, optionally at least 10 µm, optionally at least 20 µm and optionally at least 50 µm. By increasing the thickness of the membrane 61, the robustness of the membrane 61 may be improved.

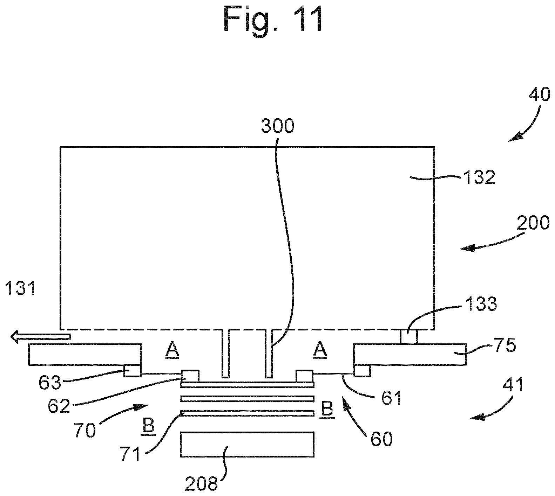

In an embodiment the seal 60 is configured to separate regions (which may be referred to as domains) that, in use, have a pressure difference between them. Different regions of an electron-optical apparatus 40 may be maintained at different pressures. For example **FIG. 11** shows region A and region B which may be maintained at different pressures. In an embodiment the electron-optical device 41 is part of an electron-optical apparatus 40. The electron-optical apparatus 40 may have features as described elsewhere with reference to **FIGs. 1-8****,** for example.

For example, a region in which the source 201 is located may be maintained at a lower pressure compared to any other region of the electron-optical apparatus 40, such as a region in which the assembly 70 is located or a region between the sample 208 and the electron-optical device 41.. For example, it may be desirable to maintain an ultrahigh vacuum (very low pressure, for example 10⁻⁹ mbar or lower pressure) at the source 201 and a high (but not ultrahigh) vacuum closer to the sample 208. As a result of the pressure difference, in general fluid which may comprise gas molecules may be expected to flow towards the region of the source 201. By providing the seal 60, the fluid conductance towards the region that is maintained at a lower pressure may be reduced. This helps to maintain the low pressure for example at the source. By maintaining the low pressure near the cathode, for example, the lifetime of the source 201 may be improved.

In an embodiment the electron-optical device 41 comprises chambers defining the respective regions and configured to be at respective vacuums. In an embodiment the electron-optical apparatus 40 comprises the chambers that define the respective regions. Different chambers may be associated with different sections of the electron-optical device 41, for example along the beam path through the electron-optical device. For example the electron-optical device 71 may be in a chamber proximate a sample. The source may be in a source chamber at the upbeam end of the electron-optical device.

The frame 75 may be connected to the assembly 70. In use, the frame 75 is intended to have a generally fixed location relative to the assembly 70. However, during manufacture of the electron-optical device 41 (and/or in use of the electron-optical device 41), it is possible for there to be a small amount of movement between the frame 75 and the assembly 70. If the seal 60 were completely rigid, then such relative movement may be more likely to cause undesirable deformation and/or misalignment between the frame 75 and the assembly 70. By providing that the seal 60 is compliant in at least one and preferably at least two degrees of freedom between the mechanical frame 75 and the assembly 70, the possibility of such deformation and/or misalignment is reduced.

When the seal is connected between the assembly 70 and the frame 75, it is possible that the seal 60 could apply a force between the frame 75 and the assembly 70. Any such force may be undesirable because it may lead to undesirable deformation and/or misalignment. By providing that the seal 60 is compliant in degrees of freedom between the frame 75 and the assembly 70, the possibility of undesirable forces being applied is reduced.

As shown in **FIG. 9****,** in an embodiment the seal 60 comprises an assembly connector 62. The assembly connector 62 is configured to connect the seal 60 to the assembly 70. As shown in **FIG. 9****,** in an embodiment the membrane 61 of the seal 60 is connected to the assembly 70 via the assembly connector 62.

As shown in **FIG. 9****,** in an embodiment the assembly 70 comprises at least one support 72. The support 72 may be provided to improve, for example provide, mechanical support of the electron-optical element 71. The support 72 may be configured to electrically isolate the electron-optical element 71 from one or more other components of the electron-optical device 41. In an embodiment the support 72 comprises an electrical insulator. As shown in **FIG. 9****,** in an embodiment the assembly connector 62 is connected to the support 72. The electron-optical element 71 is connected to the assembly connector 62 via the support 72. As shown in **FIG. 9****,** in an embodiment the frame 75 is connected to a support 72 of the assembly 70. In an embodiment the assembly 70 comprises at least two supports 72. Such supports 72 may be upbeam of the electron-optical element 71, downbeam of the electron-optical element or one either side of the electron-optical element 71. In an embodiment the electron-optical element 71 is located between two supports 72. Having the assembly connector 62 as part of the seal 60 secured to the assembly 70, the mechanical connection between the seal 60 and the assembly 70 may be more reliable and/or more robust.

As shown in **FIG. 9****,** in an embodiment the seal 60 comprises a frame connector 63. The frame connector 63 is configured to connect the seal 60 to the frame 75. In an embodiment the frame connector 63 is configured to secure the membrane 61 to the frame 75. The membrane 61 may be connected to the frame 75 via the frame connector 63. As shown in **FIG. 9****,** in an embodiment the membrane 61 extends between the frame connector 63 and the assembly connector 62.

In an embodiment the assembly connector 62 and/or the frame connector 63 extends substantially continuously around the path for the beam. When viewed along the path, the assembly connector 62 and/or the frame connector 63 may surround the path. In an embodiment one or both of the assembly connector 62 and/or the frame connector 63 are shaped respectively as an annulus. Alternatively or additionally, at least one of the frame connector 63 and the assembly connector 62 may be shaped as a polygon, for example as a hexagon or an octagon.

As shown in **FIG. 9****,** in an embodiment the membrane 61 is secured to the assembly connector 62. For example, in an embodiment the membrane 61 is soldered or welded to the assembly connector 62. Alternatively, the membrane 61 may be adhered to the assembly connector 62. Alternatively or additionally, the membrane 61 may be clamped to the assembly connector 62. For example, the assembly connector 62 may come in to pieces and the membrane 61 may be clamped between the two pieces of the assembly connector 62.

As shown in **FIG. 9****,** in an embodiment the membrane 61 is connected to the frame connector 63. For example, the membrane 61 may be soldered or welded to the frame connector 63. Alternatively, the membrane 61 may be adhered to the frame connector 63. Additionally or alternatively, the membrane 61 may be clamped to the frame connector 63. For example, the frame connector 63 may comprise two portions and the membrane 61 may be clamped between the two portions of the frame connector 63.

As shown in **FIG. 9****,** in an embodiment the membrane 61 extended from a position, such as a mid-point, along the path direction of at least one of the assembly connector 62 and the frame connector 63. Additionally or alternatively, the membrane 61 may be extended from an upbeam end or a downbeam end, for example upbeam surface or downbeam surface, of one or both of the assembly connector 62 and the frame connector 63.

As shown in **FIG. 9****,** in an embodiment the assembly connector 62 is radially inward of the frame connector 63 when viewed along the path. For example, when the electron-optical device 41 is viewed along a direction orthogonal to a plane of the seal 60, the assembly connector 62 is radially inward of the frame connector 63. The radial direction is relative to the electron-optical axis, which may extend through a centre of the electron-optical element 71. As shown in **FIG. 9****,** the shortest distance between the assembly connector 62 and the electron-optical axis is less than the shortest distance between the frame connector 63 and the electron-optical axis. However, it is not essential for the assembly connector 62 to be radially inward of the frame connector 63. In an alternative embodiment, the assembly connector 62 and the frame connector 63 may be located at substantially the same distance from the electron-optical axis. The membrane may be substantially cylindrical. The membrane 62 may form a short cylinder shape. In a different embodiment, the assembly connector 62 may be radially outward of the frame connector 63. In another arrangement, there may be a displacement along the beam path between the assembly connector and the frame connector. It is desirable that whatever the orientation of the seal, the seal has a freedom of movement in at least one direction for example at least in a direction of the beam path, or about at least one axis across the beam path.

As shown in **FIG. 9****,** in an embodiment the seal 60 is planar. In the arrangement shown in **FIG. 9****,** the plane of the seal is in the left-right direction and into-and-out of the page. By providing that the seal 60 is planar, the seal 60 may extend a smaller distance in a direction along the path of the beam. The seal 60 may be compact in a direction along the beam path. By providing that the seal 60 extends over a shorter distance along the direction of the path, the length of the path may be reduced. By reducing the length of the path, the repulsion between electrons along the beam path where there is just one beam, and between electrons along the beam paths of different beams (for example between different beams) may be reduced. An embodiment of the invention is expected to reduce undesirable gas flow and maintain desired vacuum environments in different regions of the electron-optical apparatus, without unduly increasing the risk of introducing beam aberrations.

In an embodiment at least one of the assembly connectors 62 and the frame connector 63 comprises an electrical insulator. In an embodiment both of the assembly connectors 62 and the frame connector 63 comprises an electrical insulator. By providing that the assembly connector 62 comprises an electrical insulator, the possibility of undesirable electrical breakdown may be reduced. The assembly connector 62 may be relatively close to the electron-optical element 71. The electron-optical element 71, in use may be maintained at a relatively high voltage. In an embodiment the electrical insulator is ceramic, a glass or a quartz, for example. In an embodiment the electrical insulator is formed of the same material (or a material having similar properties) as the material of one or more supports that space between adjoining plates of a stack of the assembly 70. In an embodiment the electrical insulator is formed of a material that has properties of low outgassing and electrically isolating. It is not essential for the assembly connector 62 and the frame connector 63 to be electrical insulators. In an alternative embodiment, the frame connector 63 comprises, for example consists of, a metal.

In an embodiment the assembly connector 62 is clamped to the assembly 70. In an embodiment the frame connector 63 is clamped to the frame 75. In the example shown in **FIG. 9****,** the frame connector 63 is clamped to the frame 75. The frame connector 63 may be clamped to the frame 75 via a clamp 69. In an embodiment a plurality of clamps 69 are provided for clamping the frame connector 63 to the frame 75. For example, two, three, four, or more than four clamps 69 may be provided. In an embodiment the clamp 69 functions as a leaf spring. For example, the clamp 69 may be secured (e.g. bolted) to the frame 75. The clamp 69 may be arranged to urge the frame connector 63 into engagement with a surface of the frame 75.

Although not shown in **FIG. 9****,** in an embodiment one or more clamps are provided for similarly clamping the assembly connector 62 to the assembly 70. In an embodiment, the assembly connector 62 is adhered to the assembly 70. By using an adhesive to secure the assembly connector 62 to the assembly 70, the possibility of undesirably applying a force on the assembly 70 when connecting the seal 60 may be reduced. In an embodiment, the frame connector 63 is adhered to the frame 75. By using a mechanical connection such as a clamp, it is not necessary to use an adhesive. By reducing the use of adhesives, the possibility of outgassing is reduced. An embodiment of the invention is expected to reduce contamination due to outgassing.

**FIG. 10** is a schematic cross-sectional view of a portion of an electron-optical device 41. The electron-optical device 41 may have the features described above with reference to **FIG. 9****.** These features are not repeated below. The drawing of **FIG. 10** does not show the assembly 70, or the connection between the assembly 70 and the frame 75 which is shown at the bottom of **FIG. 9****.**

As shown in **FIG. 10****,** in an embodiment the seal 60 comprises a sealing member 65. The sealing member 65 is configured to seal between the frame connector 63 and the frame 75. By providing the sealing member 65, the possibility of fluid flowing between the frame 75 and the frame connector 63 is reduced.

In an embodiment the sealing member 65 comprises a metal. In an embodiment the sealing member 65 consists of a metal. As shown in **FIG. 10****,** in an embodiment the sealing member 65 is thin and flat, for example planar. In an embodiment the sealing member 65 is foil.

**FIG. 10**In an embodiment the sealing member 65 is adjacent to a surface (for example an upbeam surface) of the frame connector 63. Although not shown in **FIG. 10****,** in an embodiment a sealing member as described above is provided between the assembly connector 62 and the assembly 70.

As shown in **FIG. 10****,** in an embodiment the frame connector 63 comprises ridge 64 so as to form an L-shape in cross-section. The surfaces of the frame 75 may be shaped opposingly to the frame connector to form an L-shape by either comprising a recess or protrusion for the sealing surface for securing the sealing member 65. The L-shape may increase the rigidity of the seal 60. This may help to reduce the possibility of the seal 60 undesirably deforming, for example due to a force exerted by the clamp 69. The frame connector 63 is shaped so as to form a bent path in cross-section between the frame 75 and the frame connector 63. The sealing member prevents flow of fluid between the frame 75 and the frame connector 63.

In an embodiment the sealing member 65 is formed from a long length or 'string', for example a metal string. The string may be compressed when the frame 75 is connected to the frame connector 63. For example, the string may flatten to form the foil sealing member 65 as shown in **FIG. 10****.** In an embodiment the sealing member 65 is formed from a relatively soft metal such as indium.

It should be noted that the electron-optical apparatus for example as described with reference to and shown in any of **FIGs. 2****,** **3****,** **4****,** **7** **and** **8** may comprise multiple modules. The modules are separable units comprising different parts of the electron-optical device 41 which may include the source. Such separable modules may be referred to as replaceable modules or "field replaceable" modules because the modules may be replaced in the field. More specifically different modules of the same electron-optical apparatus comprise different sections of the electron-optical device. The different sections are at different parts of the electron-optical device along the beam path. The modules may comprise a respective frame that provides a respective frame of reference for the respective section of the electron-optical device. On assembly, the different sections of the electron-optical device require accurate alignment with respect to a part of the electron-optical device which is often the source. In an embodiment, alignment may be achieved for each electron-optical device with respect to the source via a respective frame. The frames of the respective sections may have a positional relationship with respect to the source. Alignment of a section of the electron-optical device to the source is also relative to the respective frame. Accurate alignment helps to ensure that aberrations and distortions are reduced, minimized or even prevented. Alignment helps to ensure that corresponding electron-optical elements in an array are positioned to operate on the same beam; for example the corresponding control lens, objective lens and detector element are well aligned. For accurate alignment of the electron-optical elements of adjoining sections, the modules of the respective adjoining section may require correct alignment. This may be achieved when securing the adjoining modules together, for example by securing the frames of adjoining modules together. Aligned modules is a precondition for aligned electron-optics of the adjoining sections.

The different sections of the electron-optical device and modules may be associated with a respective region (or vacuum region). It should be noted that a vacuum region may not be confined to a module and the separation between different vacuum regions may be positioned long the beam path relative to where two modules adjoining. In an embodiment the seal 60 is provided to maintain different pressures in different regions of the electron-optical device 41 or of the electron-optical apparatus 40. For example, the seal 60 may be provided to prevent fluid passing between the vacuum regions associated with adjoining modules. In an embodiment, the seal may permit maintenance of alignment of the assembly 70 in the electron-optical device, for example via the frame 75, with other electron-optical components of the electron-optical apparatus along the beam path, such as the source 201 such as in the event of a disturbance force. The compliancy of the seal may enable the seal to maintain its relative position with the frame in at least one degree of freedom with the frame for permitting such maintenance of alignment, for example, with the beam path such as another component of the electron-optical apparatus such as the source 201. Alignment may be maintained in two or three degrees of freedom for example with respect to a position across the beam path or around the beam path, such as x, y and Rz. The compliant seal may enable the assembly to retain its relative position within the frame with respect to the respective module, i.e. the module which comprises the assembly 70 and the frame 75. Note, the description of the function of the seal to maintain alignment of the assembly with the beam path is a possible application of the seal. In a different module, the seal may be between modules of the electron-optical apparatus 40

In an embodiment the electron-optical apparatus 40 comprises one or more modules corresponding to respective regions. In an embodiment the modules are removable. For example, the modules may be replaceable or field replaceable. Such replaceability means that a module can be removed and replaced with a replacement module without substantially dismantling the rest of the electron-optical apparatus 40. Beneficially having the seal within a frame facilitates enables removal of a module. The seal is within the module rather being between modules. A seal between modules would require breaking of such as seal for removal of a module to which the seal is secured.

In an embodiment the seal 60 is arranged to separate two regions for example a more upbeam region A such as a source region 200 from another region, for example a more downbeam region B. For example, **FIG. 11** is a schematic view of a portion of an electron-optical apparatus 40 comprising a source module 132 in which the source 201 is located. The source region 200 may be comprised within the source module 132 and defined in part by the seal 60. In an embodiment the electron-optical apparatus 40 comprises an environment seal 133. The environment seal 133 is configured to seal between the source module 132 and the frame 75. In an embodiment the environment seal 133 is configured to secure the source module 132 to the frame 75. In an embodiment the environment seal 133 is configured to seal the source module 132 and the assembly 70 from the environment external to the electron-optical apparatus 40 (e.g. the atmosphere). In an embodiment a vacuum pump is configured to pump fluid from the source region 200, as indicated by the arrow 131. As shown in **FIG. 11****,** in an embodiment the beam tube 300 is part of the source module 132. The beam tube may be within the the source region 200. In an embodiment a separate region may be within the beam tube. In such an arrangement the region within the beam tube may be at a deeper vacuum than the depicted source region 200. In a different embodiment the region within the beam tube is part of the source region. In such an arrangement the region in the beam tube is at substantially the same pressure as the rest of the source region 200. The beam tube 300 may extend towards the electron-optical device 41. As shown in **FIG. 11****,** in an embodiment the electron-optical device 41 comprises a stack of electron-optical elements 71, for example as plates, in an assembly 70. The assembly 70 is provided between the sample 208 and the beam tube 300. The assembly is located between a sample region and the source region 200. In an embodiment the assembly 70 comprises an objective lens array configured to focus beams onto the sample 208, for example as shown in and described with reference to **FIGs. 3****,** **4****,** **7** **and** **8****.** In an embodiment the assembly 70 comprises a detector configured to detect signal electrons from the sample 208.

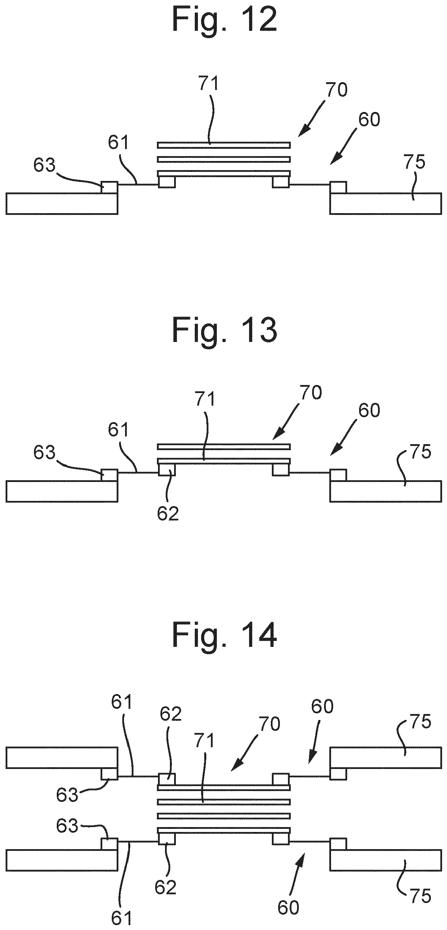

The seal 60 may be provided to separate vacuum regimes of different regions such as within the electron-optical apparatus. The seal 60 may in part defined a barrier between two adjoining regions of different vacuum regime, for example the source region and the sample region as shown and described with reference to **FIG. 11****.** Another example is shown in **FIG. 12. FIG. 12** depicts an embodiment of the assembly 70 comprising electron-optical elements 71 configured to function as an array of condenser lenses, which comprises a plurality of plates with apertures which function as lenses, such as condenser lenses 231. An electron-optical device featuring such an array of condenser lenses is shown in and described with reference to **FIG. 3****.** There may be a source region above the condenser lens array and a condenser region down beam of the array of condenser lenses 231 or at least the assembly 70. The array of condenser lenses 231 may be configured to focus the beams at an intermediate focus plane. In an embodiment the seal 60 is configured to block the flow of fluid between the condenser region (downbeam direction of condenser lenses 231) and the source region 200.

In an embodiment the seal 60 is provided to reduce, if not block, the fluid flow (e.g. of molecules, particles, gas, and contaminants) between the condenser region (e.g. of the array of condenser lenses 231) and a downbeam region, for example such as the sample region, for example a region in which an objective lens array is located, or at least defined by the most downbeam surface of a stack comprising the objective lens array, such as shown in and described with reference to **FIG. 11****.**

**FIG. 3** shows a horizontal dashed lined between the source 201 and the array of condenser lenses 231. The source region 200 is positioned above the horizontal dashed line 410, along the path of the source beam to the array of condenser lenses 231. The condenser region 206 (e.g. of the array of condenser lenses 231) is located below the horizontal dashed line 410. In an embodiment the seal 60 is configured to reduce a fluid flow between the condenser region 206 and the source region 200.

**FIG. 3** shows another horizontal dashed line 412 between the collimators (e.g. as a deflector array) and the control lens array 250. In an embodiment the seal 60 is configured to reduce a fluid flow between the condenser region 206 (which may comprise the collimators and the condenser lens array) and the sample region 205 (which may contain the control lens array 250, or at least in part be defined by a stack of the assembly comprising the control lens array 250). Thus the risk a fluid flow (e.g. of gas, particles and contaminants) flowing from the sample region upbeam may be suppressed if not prevented. Such gas may include products of outgassing such as water and hydrocarbon molecules. In an embodiment the sample region 205 may contain the objective lens array (or at least in part be defined a by a stack of the assembly comprising the objective lens array). In a different embodiment the objective lens array may be in the sample region 205, and the region in which the control lens array is contained is a different region such as a control lens region.

The seal 60 may be provided to separate different regions of other electron-optical elements of the electron-optical device. These different regions, like the arrangement described with reference to and shown in **FIG. 11** and **FIG. 12****,** have different vacuum regimes. For example, as shown in **FIG. 13****,** in an embodiment the assembly 70 comprises electron-optical elements 71 arranged along the beam path e.g., as a stack and configured to function so as to adjust the relative divergence along the beam path, for example a collimator for example in the form of an array of deflectors 235. The divergence adjustment arrangement may be configured to reduce the divergence of the one or more beams. For example, in an embodiment the divergence adjustment arrangement is configured to collimate the one or more beams. The collimator may be configured to operate on the one or more beams to collimate them. For example the array of deflectors 235 may deflect, e.g. collimate, a plurality of beams. In an embodiment the seal 60 is configured to reduce, if not block, the fluid flow between an upper region upbeam of the array of deflectors and a lower region downbeam of the deflectors 235.

It should be noted that a component of the electron-optical apparatus that at least partially collimates the beam path (for a single beam such as a source beam) or the relative directions of different beams of a beam grid, such as a condenser lens or collimator may be referred to as a divergence adjustment arrangement. Such a divergence adjustment arrangement is configured to reduce the divergence of the one or more beams. In an embodiment such a divergence adjustment arrangement may be comprised in a region which is defined in at least part relative to an adjoining region by the seal 60. In an embodiment the seal 60 is provided to reduce if not stop the fluid flow between the adjoining regions. Such an adjoining region may be a source region containing a source, a control lens region containing a control lens array, or a sample region containing an objective lens array and/or a detector.

**FIG. 4** shows a dashed line 414 between the source 201 and the macro collimator 270. The source region 200 is shown above the horizontal dashed line 414. The region of the macro collimator 270 (or collimator region 203) is shown below the horizontal dashed line 414. In an embodiment the seal 60 may reduce a fluid flow (e.g. a flow of gas molecules) between the collimator region 203 and the source region 200, for example in an upbeam direction. The seal may permit maintenance of alignment for electron-optics in the module relative to a module in which the macro collimator is comprised, for example relative to a frame of the module. Via the frame of the respective module the alignment of the macro collimator may be maintained such as with respect to the source 201.

**FIG. 4** shows another dashed line 416 between the macro collimator 270 and the macro scan deflector 265. The macro scan deflector is in a scan deflector region 204 which is downbeam of the collimator region 203, or at least the most downbeam surface of a stack comprising the macro scan deflector defines the scan deflector region 204. In an embodiment the seal 60 may help reduce a flow of fluid between the collimator region 203 and the scan deflector region 204 for example in an upbeam direction e.g. into the collimator region 203. The seal may permit maintenance of alignment of the macro scan deflector in the electron-optical apparatus, for example via the frame of the respective module of the macro scan deflector for example with respect to the source 201.

**FIG. 4** shows a further dashed line 418 between the macro scan deflector 265 and an assembly comprising a stack of electron-optical elements, such as a beam limiting aperture array and/or the control lens array 250. The stack may comprise the objective lens array 401. The macro scan deflector may be in a scan deflector region and the control lens array may be in, or at least the most downbeam surface of the stack comprising the control lens array is in the sample region 205. In an embodiment the seal 60 may reduce a fluid flow (e.g. a flow of particles) between the region of the macro scan deflector 265 and the region of stack 50 for example in a fluid flow in an upbeam direction. The seal 60 may permit maintenance of alignment of the assembly (comprising for example the control lens array and the objective lens array) in the electron-optical apparatus. For example the alignment is via the frame of the respective module of the assembly for example with respect to the source 201.

The regions mentioned above may correspond to respective modules. For example, a module may be provided for one or more of the source 201, the macro scan deflector 265, the macro collimator 270, the condenser lenses 231, the deflectors 235 and the control lens array 250. The module of the control lens array 250 may include the objective lens array and/or the detector 240.

The electron-optical apparatus 40 shown in **FIG. 7** or **FIG. 8** may comprise a plurality of modules with regions maintained at different pressures. One or more seals 60 may be provided to maintain the pressure differences. In having the seals of the present invention seal the adjoining vacuums of adjoining regions that are associated with adjoining replaceable modules, the replaceable functionality of the modules is independent of the sealing between the adjoining regions when the boundary of the regions are in part also defined by the electron-optocal elements such as the assembly 70.. The seals do not have to be broken between modules when removing one of the modules from the apparatus. Thus the seals can be secured to seal the adjoining regions without the need to remake the seal on replacement of the modules and for pumping down.

In an embodiment a module is provided with a plurality of the seal 60. For example, seals 60 may be provided at both of an upbeam end and a downbeam end of a module. **FIG. 14** schematically shows an assembly 70 of electron-optical elements 71. Seals 60 are provide at both the upbeam end and the downbeam end of the assembly 70. In an embodiment the frame 75 shown at one end is connected to, for example secured to or integral with, the frame 7 shown at the other end. Such an arrangement may be used in the electron-optical apparatus shown in and described with reference to **FIG. 3** and **FIG. 4****,** for example for the modules associated with the collimator region, the scan deflector region, and the condenser region.

In general, the seal 60 may be provided to reduce, if not prevent, block or stop, fluid flow e.g. of molecules between any two regions of the electron-optical apparatus 40. This helps to maintain the different pressures of the different regions. In an embodiment a plurality of seals 60 are provided for separating different pairs of regions.

Reference to a component or system of components or elements being controllable to manipulate a charged particle beam in a certain manner includes configuring a controller or control system or control unit to control the component to manipulate the charged particle beam in the manner described, as well as optionally using other controllers or devices (e.g., voltage supplies and/or current supplies) to control the component to manipulate the charged particle beam in this manner. For example, a voltage supply may be electrically connected to one or more components to apply potentials to the components, such as in a non-limited list including the control lens array 250 and the objective lens array 241.

References to upper and lower, up and down, above and below, etc. should be understood as referring to directions parallel to the (typically but not always vertical) upbeam and downbeam directions of charged particle beams impinging on the sample 208. The terms upbeam and downbeam are relative directions in the electron-optical apparatus. It is not intended that a beam is required to be present for these terms to have meaning; for example it is intended that these terms are applicable when the beam of electrons is not present for example during servicing of the electron-optical device. Thus, references to upbeam and downbeam are intended to refer to directions in respect of the beam path independently of any present gravitational field and presence of a beam of electrons at specific moment in time.

Electron-optics described herein may take the form of a series of aperture arrays or electron-optical elements arranged in arrays along a beam or a multi-beam path. Such electron-optical elements may be electrostatic. In an embodiment all the electron-optical elements, for example from a beam limiting aperture array to a last electron-optical element in a beam path before a sample, may be electrostatic and/or may be in the form of an aperture array or a plate array. In some arrangements one or more of the electron-optical elements are manufactured as a microelectromechanical system (MEMS) (i.e. using MEMS manufacturing techniques). Electron-optical elements may have magnetic elements and electrostatic elements. For example, a compound array lens may feature a macro magnetic lens encompassing the multi-beam path with an upper and lower pole plate within the magnetic lens and arranged along the multi-beam path. In the pole plates may be an array of apertures for the beam paths of the multi-beam. Electrodes may be present above, below or between the pole plates to control and optimize the electromagnetic field of the compound lens array.

Although the invention is described with reference to a charged particle-optical device for projecting a plurality of beams towards a sample, the present invention may be used with a charged particle-optical device configured to project a single charged particle beam towards a sample. In such an arrangement the electron-optical components of the assembly may be configured to operate on a single beam, for example defined in a planar electron-optical element may be a single aperture. The seal may be between the assembly and frame of a module of a single bean charged particle optical device.

An assessment apparatus, tool or system according to the disclosure may comprise apparatus which makes a qualitative assessment of a sample (e.g. pass/fail), one which makes a quantitative measurement (e.g. the size of a feature) of a sample or one which generates an image of map of a sample. Examples of assessment apparatus, tools or systems are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools).

Functionality provided by the controller or control system or control unit may be computer-implemented. Any suitable combination of elements may be used to provide the required functionality, including for example CPUs, RAM, SSDs, motherboards, network connections, firmware, software, and/or other elements known in the art that allow the required computing operations to be performed. The required computing operations may be defined by one or more computer programs. The one or more computer programs may be provided in the form of media, optionally non-transitory media, storing computer readable instructions. When the computer readable instructions are read by the computer, the computer performs the required method steps. The computer may consist of a self-contained unit or a distributed computing system having plural different computers connected to each other via a network.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims and clauses.

There are provided the following clauses:
Clause 1. A charged particle-optical device for projecting one or more beams of charged particles towards a sample location, the device comprising: an assembly comprising at least one charged particle-optical element configured to operate on one or more beams of charged particles along one or more respective paths for the one or more beams towards a sample location; a frame around the path and connected to the assembly; and a seal around the path, secured between the frame and the assembly, and configured to seal between the frame and the assembly, optionally wherein the seal is compliant in at least two degrees of freedom between the frame and the assembly.
Clause 2. The charged particle-optical device of clause 1, wherein the seal is planar and/or comprises foil.
Clause 3. The charged particle-optical device of clause 1 or 2, wherein the seal comprises a metal.
Clause 4. The charged particle-optical device of any preceding clause, wherein the seal is compliant in at least one, two or three degrees of freedom between the frame and the assembly.
Clause 5. The charged particle-optical device of any preceding clause, wherein the seal is compliant in a direction of the beam path, desirably in a direction perpendicular to a plane of the seal.
Clause 6. The charged particle-optical device of any preceding clause, wherein the seal is compliant about at least one axis across the beam path, desirably in a plane of the seal.
Clause 7. The charged particle-optical device of any preceding clause, wherein the seal comprises an assembly connector configured to connect the seal to the assembly and a frame connector configured to connect the seal to the frame, desirably the seal comprises a membrane, desirably a foil, desirably the assembly connector is configured to secure the membrane to the assembly, desirably the frame connector is configured to secure the membrane to the frame.
Clause 8. The charged particle-optical device of clause 7, wherein the assembly connector is radially inward of the frame connector when viewed along the path, desirably orthogonal to a plane of the seal.
Clause 9. The charged particle-optical device of clause 7 or 8, wherein at least one of the assembly connector and the frame connector comprises an electrical insulator.
Clause 10. The charged particle-optical device of any preceding clause, wherein the assembly connector is clamped to the assembly and/or the frame connector is clamped to the frame.
Clause 11. The charged particle-optical device of any preceding clause, wherein the seal comprises a sealing member configured to seal between the frame connector and the frame.
Clause 12. The charged particle-optical device of clause 11, wherein the sealing member comprises or consists of a metal, and desirably is foil.
Clause 13. The charged particle-optical device of any preceding clause, wherein the assembly comprises a stack of charged particle-optical elements, desirably one or more of the charged particle-optical elements comprises a plate in which is defined one or more apertures, desirably the one or more charged particle optical elements are planar.
Clause 14. The charged particle-optical device of any preceding clause, wherein the at least one charged particle-optical element of the assembly comprises a condenser lens array configured to focus the beams at an intermediate focus plane and/or an objective lens array configured to focus the one or more beams onto the sample location.
Clause 15. The charged particle-optical device of any preceding clause, wherein the assembly comprises a detector configured to detect signal particles from the sample location.
Clause 16. The charged particle-optical device of any preceding clause, wherein the assembly comprises a divergence adjustment arrangement configured to reduce the divergence of the one or more beams, desirably to collimate the one or more beams.
Clause 17. The charged particle-optical device of any preceding clause, comprising: a charged particle source configured to generate charged particles for the one or more beams, wherein desirably the assembly comprises the charged particle source.
Clause 18. The charged particle-optical device of any preceding clause, comprising a module, the module comprising the frame and the assembly, desirably the seal is with the module; desirably the device comprising multiple modules, desirably the module or at least one of the modules is removeable.
Clause 19. A charged particle-optical device for projecting one or more beams of charged particles towards a sample location, the device comprising: an assembly comprising at least one charged particle-optical element configured to operate one or more beams of charged particles along a path for the one or more beams towards a sample location; a frame around the beam path and having a fixed location relative to the assembly; and a planar seal around the beam path, secured between the frame and the assembly, and configured to block gas flow from around the assembly.
Clause 20. The charged particle-optical device of clause 19, wherein the seal is compliant in at least one degree of freedom desirably at least two degrees of freedom, desirably three degrees of freedom, desirably in at least one of Rx, Ry and z relative to a plane across the beam path.
Clause 21. The charged particle-optical device of clause 19 or 20, wherein the planar seal extends in a plane between frame and the assembly.
Clause 22. The charged particle-optical device of any of clauses 19-21, wherein the planar seal is configured to be in a plane across the path.
Clause 23. A charged particle-optical apparatus comprising: the charged particle-optical device of any preceding clause.
Clause 24. The charged particle-optical apparatus of clause 23 comprising one more modules, at least one of the modules comprising the assembly, the frame and the seal.
Clause 25. The charged particle-optical apparatus of clause 23 or 24 comprising: an actuatable stage configured to support a sample at the sample location.
Clause 26. The charged particle-optical apparatus of any of clauses 23-25 comprising: one or more vacuum chambers comprising different domains and configured to be at respective vacuums, desirably the seal defining a part of a wall between different domains, desirably the frame comprising a wall of the one or more vacuum chambers, desirably a part of the assembly comprising a wall of one or more of the vacuum chambers.
Clause 27.A method for manufacturing a charged particle-optical device for projecting one or more beams of charged particles towards a sample location, the method comprising: providing an assembly comprising at least one charged particle-optical element configured to direct one or more beams of charged particles along one or more respective paths for the one or more beams towards a sample location; connecting a frame to the assembly such that the frame is around the path; and securing a seal between the frame and the assembly such that the seal is around the path, the seal configured to seal between the frame and the assembly.
Clause 28. The method of clause 27, wherein the seal is secured after connecting the frame to the assembly.
Clause 29. The method of clause 27 or 28, wherein the seal is planar.
Clause 30. A method for manufacturing a charged particle-optical device for projecting one or more beams of charged particles towards a sample location, the method comprising: providing an assembly comprising at least one charged particle-optical element configured to operate one or more beams of charged particles along a path for the one or more beams towards a sample location; fixing a location of the frame relative to the assembly such that the frame is around the beam path; and securing a planar seal between the frame and the assembly such that the planar seal is around the beam path, the planar seal configured to block gas flow from around the assembly.
Clause 31. The method of any of clauses 27-30, wherein the seal prior to the securing is compliant in more degrees of freedom than after the securing.
Clause 32. The method of any of clauses 27-31, wherein the seal comprises foil.
Clause 33. The method of any of clauses 27-32, wherein the seal comprises a metal.
Clause 34. The method of any of clauses 27-33, wherein the seal is compliant in at least three degrees of freedom between the frame and the assembly.
Clause 35. The method of any of clauses 27-34, wherein the seal is compliant in a direction of the beam path, desirably in a direction perpendicular to a plane of the seal.
Clause 36. The method of any of clauses 27-35, wherein the seal is compliant about at least one axis across the beam path, desirably in a plane of the seal.
Clause 37. The method of any of clauses 27-36, wherein the seal comprises an assembly connector configured to connect the seal to the assembly and a frame connector configured to connect the seal to the frame, desirably the seal comprises a membrane, desirably a foil, desirably the assembly connector is configured to secure the membrane to the assembly, desirably the frame connector is configured to secure the membrane to the frame.
Clause 38. The method of clause 37, wherein the assembly connector is radially inward of the frame connector when viewed along the path, desirably orthogonal to a plane of the seal.
Clause 39. The method of clause 37 or 38, wherein at least one of the assembly connector and the frame connector comprises an electrical insulator.
Clause 40. The method of any of clauses 27-39, comprising clamping the assembly connector to the assembly and/or clamping the frame connector to the frame.
Clause 41.The method of any of clauses 27-40, wherein the seal comprises a sealing member configured to seal between the frame connector and the frame.
Clause 42. The method of clause 41, wherein the sealing member comprises or consists of a metal, and desirably is foil.
Clause 43. The method of any of clauses 27-42, wherein the assembly comprises a stack of charged particle-optical elements, desirably one or more of the charged particle-optical elements comprises a plate in which is defined one or more apertures, desirably the one or more charged particle optical elements are planar.
Clause 44. The method of any of clauses 27-43, wherein the at least one charged particle-optical element of the assembly comprises a condenser lens array configured to focus the beams at an intermediate focus plane and/or an objective lens array configured to focus the one or more beams onto the sample location.
Clause 45. The method of any of clauses 27-44, wherein the assembly comprises a detector configured to detect signal particles from the sample location.
Clause 46. The method of any of clauses 27-45, wherein the assembly comprises a divergence adjustment arrangement configured to reduce the divergence of the one or more beams, desirably to collimate the one or more beams.
Clause 47. The method of any of clauses 27-46, comprising: a charged particle source configured to generate charged particles for the one or more beams, wherein desirably the assembly comprises the charged particle source.
Clause 48. The method of any of clauses 27-47, comprising a module, the module comprising the frame and the assembly, desirably the seal is with the module; desirably the device comprising multiple modules, desirably the module or at least one of the modules is removeable.

## Claims

1. A charged particle-optical device for projecting one or more beams of charged particles towards a sample location, the device comprising:
an assembly comprising at least one charged particle-optical element configured to operate on one or more beams of charged particles along one or more respective paths for the one or more beams towards a sample location;
a frame around the path and connected to the assembly; and
a seal around the path, secured between the frame and the assembly, and configured to seal between the frame and the assembly.

2. The charged particle-optical device of claim 1, wherein the seal is planar and/or comprises foil.

3. The charged particle-optical device of claim 1 or 2, wherein the seal comprises a metal.

4. The charged particle-optical device of any preceding claim, wherein the seal is compliant in at least one degree of freedom between the frame and the assembly.

5. The charged particle-optical device of any preceding claim, wherein the seal is compliant in a direction of the beam path, desirably in a direction perpendicular to a plane of the seal.

6. The charged particle-optical device of any preceding claim, wherein the seal is compliant about at least one axis across the beam path, desirably in a plane of the seal.

7. The charged particle-optical device of any preceding claim, wherein the seal comprises an assembly connector configured to connect the seal to the assembly and a frame connector configured to connect the seal to the frame.

8. The charged particle-optical device of claim 7, wherein the assembly connector is radially inward of the frame connector when viewed along the path, desirably orthogonal to a plane of the seal.

9. The charged particle-optical device of claim 7 or 8, wherein at least one of the assembly connector and the frame connector comprises an electrical insulator.

10. The charged particle-optical device of any preceding claim, wherein the assembly connector is clamped to the assembly and/or the frame connector is clamped to the frame.

11. The charged particle-optical device of any preceding claim, wherein the seal comprises a sealing member configured to seal between the frame connector and the frame, optionally wherein the sealing member comprises or consists of a metal, and desirably is foil.

12. The charged particle-optical device of any preceding claim, wherein the assembly comprises a stack of charged particle-optical elements and/or a detector configured to detect signal particles from the sample location.

13. The charged particle-optical device of any preceding claim, comprising a module, the module comprising the frame and the assembly, desirably the seal is with the module; desirably the device comprising multiple modules, desirably the module or at least one of the modules is removeable.

14. A charged particle-optical apparatus comprising:
the charged particle-optical device of any preceding claim; and
one or more vacuum chambers comprising different domains and configured to be at respective vacuums, desirably the seal defining a part of a wall between different domains, desirably the frame comprising a wall of the one or more vacuum chambers, desirably a part of the assembly comprising a wall of one or more of the vacuum chambers.

15. A method for manufacturing a charged particle-optical device for projecting one or more beams of charged particles towards a sample location, the method comprising:
providing an assembly comprising at least one charged particle-optical element configured to direct one or more beams of charged particles along one or more respective paths for the one or more beams towards a sample location;
connecting a frame to the assembly such that the frame is around the path; and
securing a seal between the frame and the assembly such that the seal is around the path, the seal configured to seal between the frame and the assembly.
